# EUROPEAN PATENT SPECIFICATION

(11) **EP 1 253 714 B1**
(45) Date of publication and mention of the grant of the patent: **18.10.2006**
(21) Application number: 02252905.1
(22) Date of filing: 24.04.2002
(51) Int. Cl.: H03H 11/36

(54) **Radio frequency interface**
Radiofrequenzschnittstelle
Interface à radiofréquences

(30) Priority: 26.04.2001 GB 0110193
(43) Date of publication of application: 30.10.2002
(73) Proprietor: Zarlink Semiconductor Limited, Swindon, Wiltshire SN2 2QW (GB)
(72) Inventor: Cowley, Nicholas Paul, Wroughton, Wiltshire SN4 0RT (GB); Mudd, Mark Stephen John, Wooton Basset, Wiltshire SN4 7SD (GB); Madni, Ashad, Swindon, Wiltshire (GB); Lauria, Franco, Swindon, Wiltshire (GB)
(74) Representative: Robinson, John Stuart

(56) References cited:
- EP-A- 0 797 298
- GB-A- 2 322 490
- US-A- 4 471 317

## Description

The present invention relates to an input interface for interfacing between a radio frequency input and a plurality of radio frequency tuners. Such an interface may be used as a "front end", for example for connection to a digital cable distribution system and may be provided in a "set top box". The present invention also relates to a combination of such an interface and at least one tuner, which may form such a set top box.

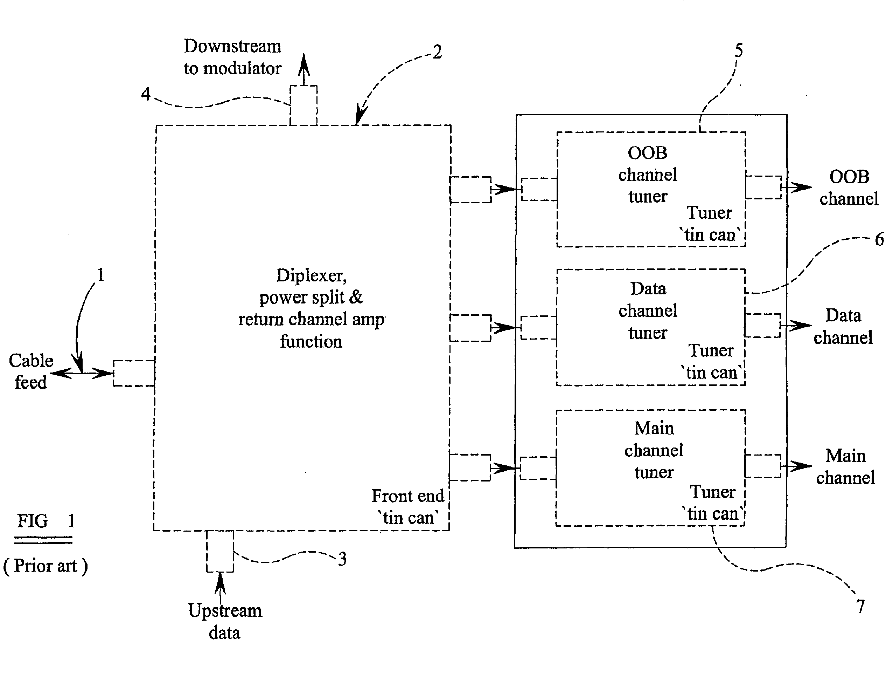

Figure 1 of the accompanying drawings illustrates the layout of a typical known type of set top box front end. The front end is connected to a bidirectional cable feed 1 which allows two way communication between a system operator and a system subscriber. The front end 2 is formed in a "tin can" acting as a Faraday cage for providing electromagnetic screening of the components inside. As described in more detail hereinafter, the front end or interface comprises a diplexer and performs power splitting and return channel amplifier functions. The interface has an input 3 for receiving upstream data to be transmitted via the cable feed 1 to the cable distribution network and an output 4 which, for example, feeds a video remodulator (not shown) where the input feed is multiplexed with a channel output from a demodulator within the set top box.

The interface 2 has a plurality of outputs (three in this example) which are connected to the inputs of respective tuners, such as data tuners 5 and 6 and a main channel tuner 7, each of which is formed in a "tin can" for screening purposes. The tuners 5 to 7 convert selected channels to standard intermediate frequencies and supply these to respective demodulators (not shown).

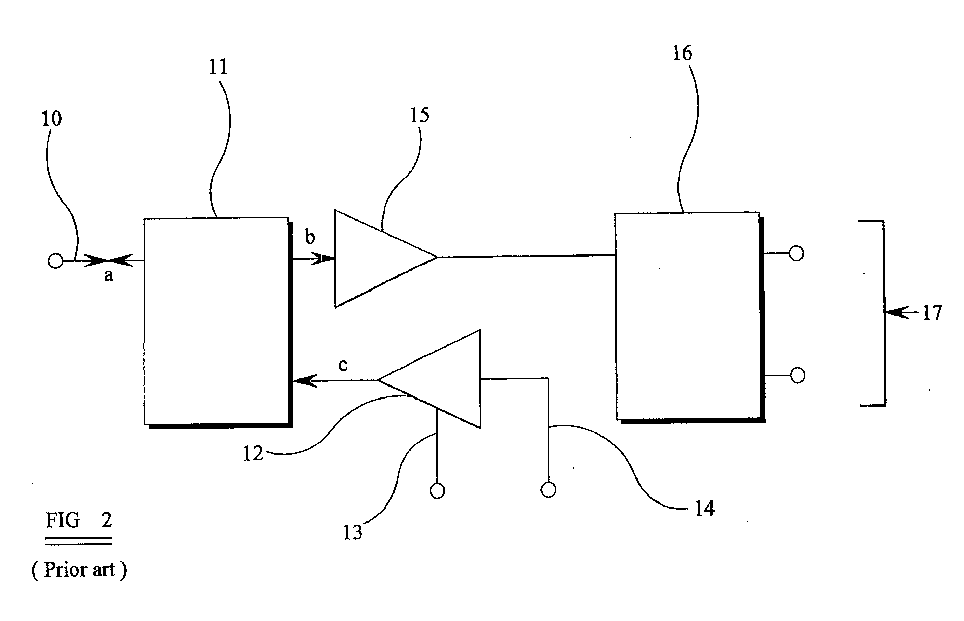

The interface 2 of Figure 1 is shown in more detail in Figure 2 of the accompanying drawings and comprises an antennae input 10 connected to an input/output terminal a of a diplexer 11 having an input c and an output b. The input c is connected to the output of a power amplifier (PAMP) 12 having a gain control input 13 for receiving an automatic gain control (AGC) control signal. The amplifier 12 has an input 14 for receiving upstream data, for example generated by an external generator.
The output b of the diplexer 11 is connected via a low noise amplifier (LNA) 15 to a power splitter 16 having outputs 17 for connection to respective tuners. The power splitter 16 comprises an array of electromagnetically coupled power splitters, such as transformers or baluns, for dividing the signal power between the outputs 17.

The purpose of the diplexer 11 is to multiplex downstream data and upstream data onto the cable feed with minimum crosstalk between the data streams. Thus, the diplexer 11 is required to have a minimum insertion loss or attenuation from the terminal a to the terminal b and from the terminal c to the terminal a but a relatively high degree of isolation between the terminals b and c. In a typical example, the bandwidth of the upstream data may be between 5 and 55 MHz and the downstream data may have a bandwidth between 65 and 860 MHz. The diplexer 11 typically has a passband of 65 to 850 MHz from the terminal a to the terminal b with an insertion loss of less than 1 dB and an attenuation of 60 dB below 55 MHz and a passband of 5 to 55 MHz from the terminal c to the terminal a with an insertion loss of 1 dB or less and an attenuation of 60 dB above 65 MHz.

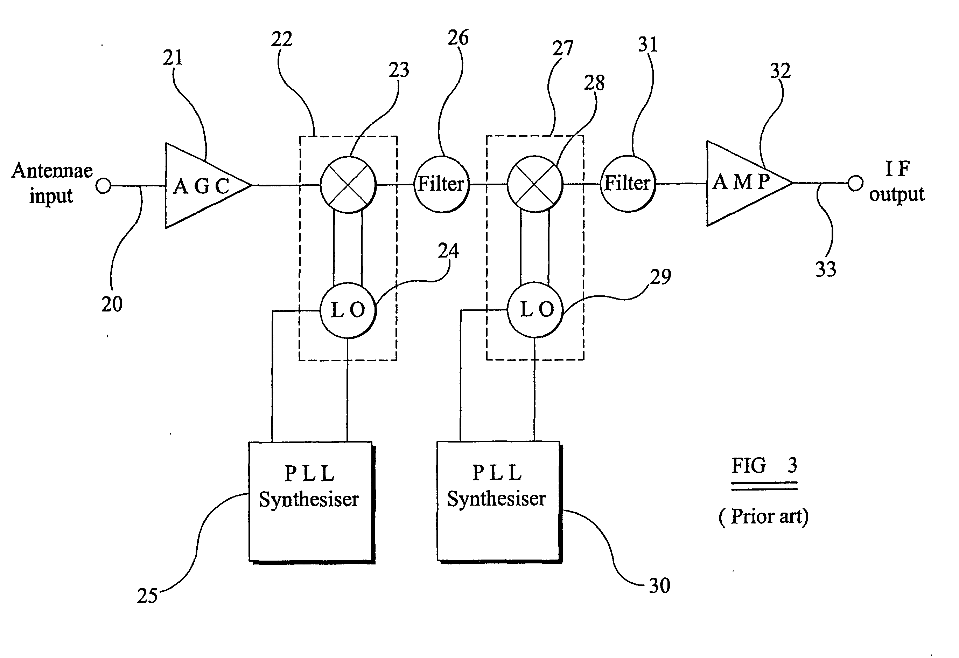

Figure 3 of the accompanying drawings illustrates a typical known type of double conversion tuner which may form any or all of the tuners 5 to 7 shown in Figure 1. The tuner has an antennae input 20 connected to an automatic gain control (AGC) circuit 21, which controls the level of the signal supplied to a first frequency changer 22 so as to maximise the signal-to-intermodulation-plus-noise performance of the tuner. The first frequency changer 22 comprises a mixer 23 and a local oscillator 24 controlled by a phase locked loop (PLL) synthesiser 25 which in turn is controlled, for example, by an I2C bus microcontroller (not shown). The frequency changer 23 performs a block up-conversion of the incoming broadband signal to a high intermediate frequency (IF) with the selected or desired channel for reception being substantially centred on the high IF. The output of the frequency changer 23 is supplied to a high IF filter 26 having a defined centre frequency and passband characteristic. The filter 26 typically passes a small number of individual channels and substantially rejects the other channels.

The output of the filter 26 is supplied to a second frequency changer 27, which is similar to the first frequency changer 22 and comprises a mixer 28, a local oscillator 29 and a phase locked loop synthesiser 30. The second frequency changer 27 performs a block down-conversion such that the desired channel is substantially centred on a second IF, which is typically 44 MHz. The output of the frequency changer 27 is supplied to an IF filter 31, which typically has a single channel bandwidth and may have a shaped passband characteristic as defined by the modulation standard of the received signal. The filter 31 substantially removes all but the desired channel and the output of the filter is amplified by an amplifier 32 before being supplied to an IF output 33 for connection to a demodulator (not shown), which may be of analogue or digital type.

This known type of arrangement has various disadvantages. For example, the electromagnetic power splitter 16 is difficult to design and the use of electromagnetic components results in lower than desirable levels of isolation between the individual components. This in turn leads to reduced isolation between the outputs 17. Also, electromagnetic components are relatively bulky and this arrangement is relatively expensive because of the cost of components and the need for adjustment during manufacture. Further, electromagnetic components are reactive by their nature and such components thus have a passband which is not flat.

US 5 168 242 discloses a type of active broadband power splitter which relies on transmission line techniques to provide a plurality of single-ended output signals having different phase shifts from the input signal. The transmission lines use reactive components, in particular series inductors and shunt capacitors, to simulate transmission lines and are connected as gate and drain lines for a plurality of field effect transistors (FET) in each of several channels. The channels are connected in cascade with one channel receiving the input signal and adjacent channels being interconnected via capacitive coupling between transmission lines.

US 5 072 199 discloses another type of active broadband power splitter in which a unity gain broadband feedback amplifier buffers the input signal to a plurality of active matching networks, each of which has a single-ended output. The amplifier comprises a common source FET with an active drain load and feedback and matching components including inductors. Each matching network comprises a source-follower with an active load.

US 5 045 822 discloses a further type of active broadband power splitter in which common source FETs have drains which form the single-ended outputs and gates connected together and to the input by a reactive network. Each FET has a shunt feedback provided by a resistor and an inductor connected in series. Cross-talk between outputs is reduced by cross-coupling through a resistor and an inductor.

US 4 668 920 discloses another active matrix broadband power splitter based on transmission line and distributed amplifier techniques. Sets of FETs have gates connected to tappings of a common input transmission line formed by inductors and drains connected to tappings of individual output transmission lines also formed by inductors.

US 4 378 537 discloses a passive broadband power splitter in which an input buffer comprising cascaded emitter-followers supplies a plurality of passive resistor-capacitor coupling networks providing single-ended outputs.

US 3 832 647 discloses a signal distribution network comprising cascade connected common base transistors. The collector of each transistor is connected to the next stage via the primary winding of a transformer whose secondary winding is connected to a respective output.

These known power splitter arrangements suffer from various disadvantages. For example, many of the arrangements rely on reactive components such as inductors to perform the power splitting with the disadvantages described hereinbefore. Passive arrangements suffer from poor isolation between their outputs.

According to a first aspect of the invention, there is provided an input interface for interfacing between a radio frequency input and a plurality of radio frequency tuners, comprising a broadband active multipath power splitter having at least one input for receiving a broadband radio frequency signal, a plurality of output channels, and at least one active power splitting circuit for supplying the broadband frequency signal to each of the channels, characterised in that the active power splitting circuit is a non-reactive power splitting circuit and at least one of the output channels comprises an automatic gain control circuit having a single-ended output connected to the input of a differential output buffer having a differential output forming the output of the channel.

The term "broadband" as used herein means a signal of relatively large frequency range comprising a plurality of channel widths and containing a plurality of channels from which a desired channel may be selected for reception. The term "active" as used herein means having at least one active component having power gain, such as a transistor. The term "non-reactive" as used herein means an arrangement which does not rely on reactive components to perform power splitting. The term "buffer" as used herein means a device or arrangement which provides a high level of electrical isolation between its input and output and which may provide gain and/or impedance change.

The differential outputs may be arranged to supply signals having substantially the same characteristics as the broadband radio frequency signal. The characteristics may, for example, include, impedance, the shape of the distribution of signal level with respect to frequency, and the like.

The interface may comprise an amplifier for supplying the radio frequency signal to the power splitter input.

The at least one input may comprise a plurality of inputs, the at least one splitting circuit may comprise a plurality of splitting circuits, and the at least one channel may comprise a multiplexer for connecting the output of any selected one of the splitting circuits to the input of the automatic gain control circuit.

The gain of the automatic gain control circuit may be controllable to be substantially zero.

The interface may be formed as a single monolithic integrated circuit.

According to a second aspect of the invention, there is provided a combination of an interface according to the first aspect of the invention and at least one tuner connected to the differential output.

The tuner may have a differential input connected to a differential output of the interface. The tuner may have a mixer with a balanced input connected to the differential input. The mixer may be a double-balanced mixer.

The combination may be disposed in a common enclosure, for example so as to form a set top box.

It is thus possible to provide an interface which may be made very compact and most or all of which may be formed as an integrated circuit. Electromagnetic splitters are not needed so that the bulk, cost and need for adjustment during manufacture can be avoided. A very high level of isolation between outputs can be provided and each broadband path through the interface can readily provide a passband with very little ripple or gain/attenuation variations. The interface may be made very compact and its cost is much less than known arrangements.

It is also possible to provide improved tuner performance. In particular, by using differential outputs connected to a suitably designed tuner, for example with a double-balanced first mixer, distortion performance can be substantially improved and, in particular, intermodulation products can be substantially reduced.

The tuners can be simplified with savings in design work and cost. Differential or balanced AGC circuits are difficult to design and generally have poorer performance. By disposing the AGC circuit ahead of the differential output buffers, the AGC function can be performed while enjoying the benefits of supplying a differential signal to the tuner, as described hereinbefore. The differential or "balanced" feed to the tuners also results in common mode rejection of spurious "noise" signals which might otherwise be coupled to the tuner inputs.

The invention will be further described by way of example, with reference to the accompanying drawings, in which:
Figure 1 is a schematic diagram of a known type of set top box;
Figure 2 is a block schematic diagram of a known type of front end interface of a set top box;
Figure 3 is a block diagram of a known type of double-conversion tuner;
Figure 4 is a block diagram of a radio frequency interface constituting an embodiment of the invention;
Figure 5 is a block diagram illustrating the interface of Figure 4 connected to a modified tuner to provide a set top box constituting an embodiment of the invention; and
Figure 6 is a block diagram of a radio frequency interface constituting another embodiment of the invention.

Like reference numerals refer to like parts throughout the drawings.

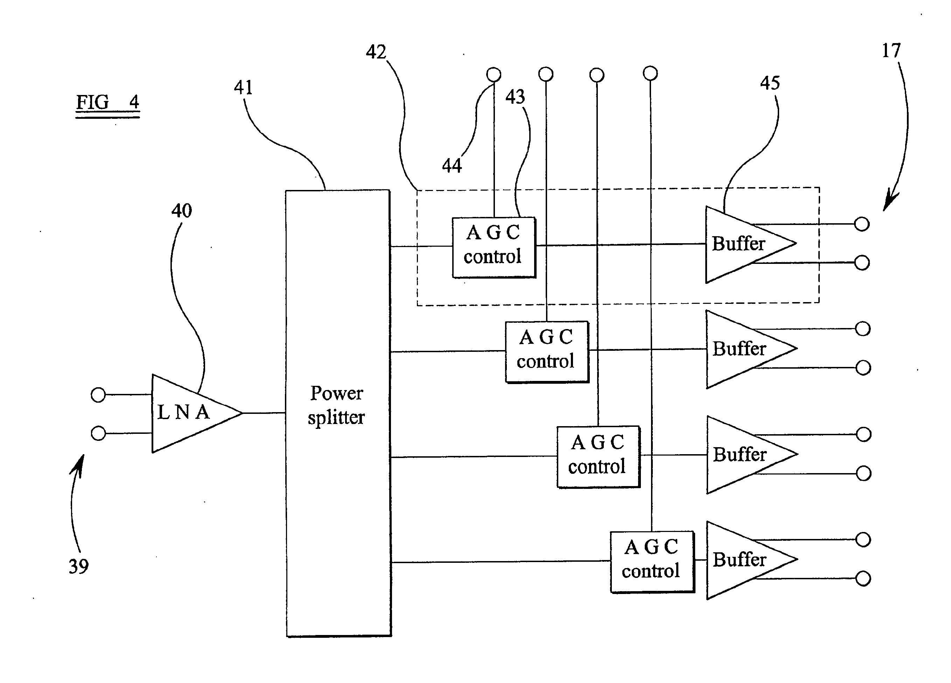

The input interface shown in Figure 4 comprises a low noise amplifier 40 connected to inputs 39 which are in turn connected to the output of a diplexer such as that shown in Figure 2. The amplifier 40 provides gain and has a noise figure and signal handling performance suitable for receiving the broadband radio frequency input signals, for example supplied from a cable distribution network via the diplexer.

The output of the amplifier 40 is supplied to the input of an active power splitter 41 which, in the example shown, has four outputs, each of which supplies an output signal whose characteristics are substantially identical to the input signal. For example, the output impedance of each output may be substantially the same as the input impedance of the input of the power splitter 41. Also, each path from the input to the respective one of the outputs of the power splitter 41 has a substantially flat frequency response across a very broad band of frequencies. The power splitter 41 is active and does not need any reactive components, such as the electromagnetic components required in known types of power splitters as illustrated in Figure 2. The power splitter 41 thus effectively splits the input signal power between the outputs, for example substantially equally.

Each of the outputs of the power splitter 41 is connected to the input of a respective channel. Only one channel 42 will be described as the other channels in the embodiment of Figure 4 are substantially identical. However, the output channels need not be identical and may, for example, have different output impedances, different automatic gain control characteristics, or have fixed gains. The channel 42 comprises an automatic gain control circuit 43 whose input is connected to the respective output of the power splitter 41. The circuit 43 has a gain control input 44 which may, for example, be connected to a control signal generating circuit within the interface or may be connected to such a circuit in a tuner to which the channel 42 is connected. The output of the circuit 43 is connected to the input of a buffer 45 which provides balanced or differential outputs 17 for connection to the input of the associated tuner. The buffer 45 may provide a suitable output impedance and may or may not have gain.

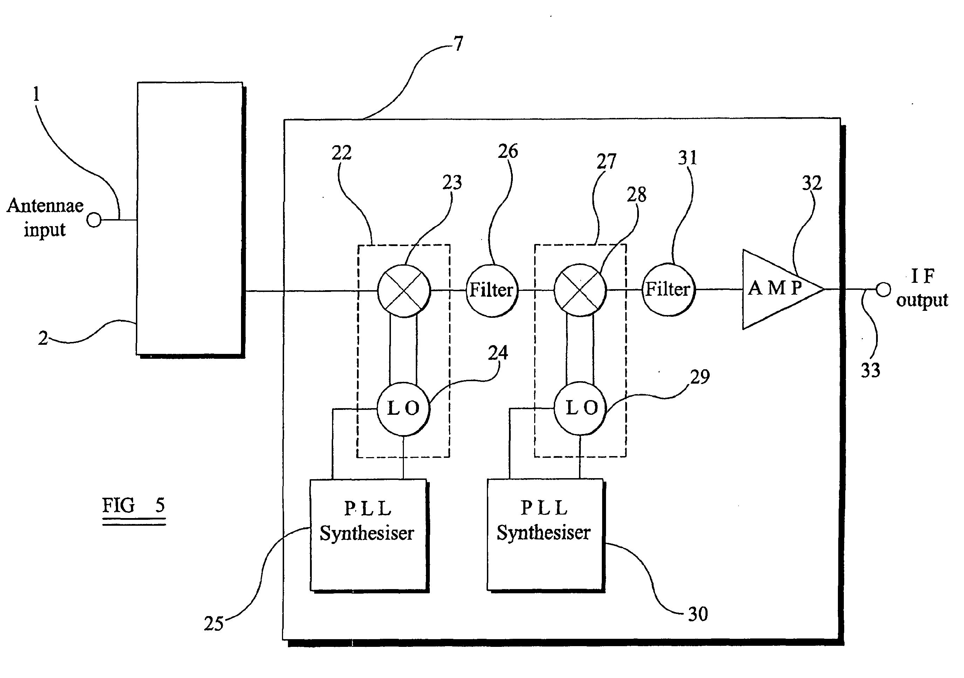

Figure 5 shows the interface of Figure 4 connected to a tuner 7. The tuner 7 is of the double conversion type and is similar to that illustrated in Figure 3. However, the tuner of Figure 5 differs from that shown in Figure 3 in that the AGC circuit 21 of the tuner of Figure 3 is omitted because this function is provided within the interface shown in Figure 4. Also, the mixer 23 of the first frequency changer 22 is of the type having differential inputs so as to benefit from the differential outputs of the interface 2. For example, the mixer 23 may be a double-balanced mixer.

All of the components of the interface shown in Figure 4 may be formed in a single integrated circuit. It is therefore possible to provide a very compact front end of reduced cost. The AGC circuit 43 can easily be implemented in the interface before the buffer 45, which converts the signal to a differential or balanced signal. This allows the connection between the interface 2 and each tuner such as 7 to be balanced and avoids the problems of providing a differential AGC circuit which would maintain amplitude and phase balance as the gain is varied. The differential signal connection to the tuner results in improved intermodulation performance and common mode rejection of spurious noise signals.

Such an arrangement also provides improved isolation between the outputs of the power splitter. Also, it is relatively easy to provide an AGC circuit 43 which is capable of functioning as an isolation switch by arranging for the gain control range to extend to zero gain. Thus, when a tuner is connected to an output of the interface via a multiplexer to permit a further signal source to be connected to the input of the tuner, for example from a demodulated digital video channel, the signal from the interface can effectively be disabled by switching the AGC circuit gain to its minimum gain setting. Thus, the need for and hence the cost of a radio frequency relay can be avoided.

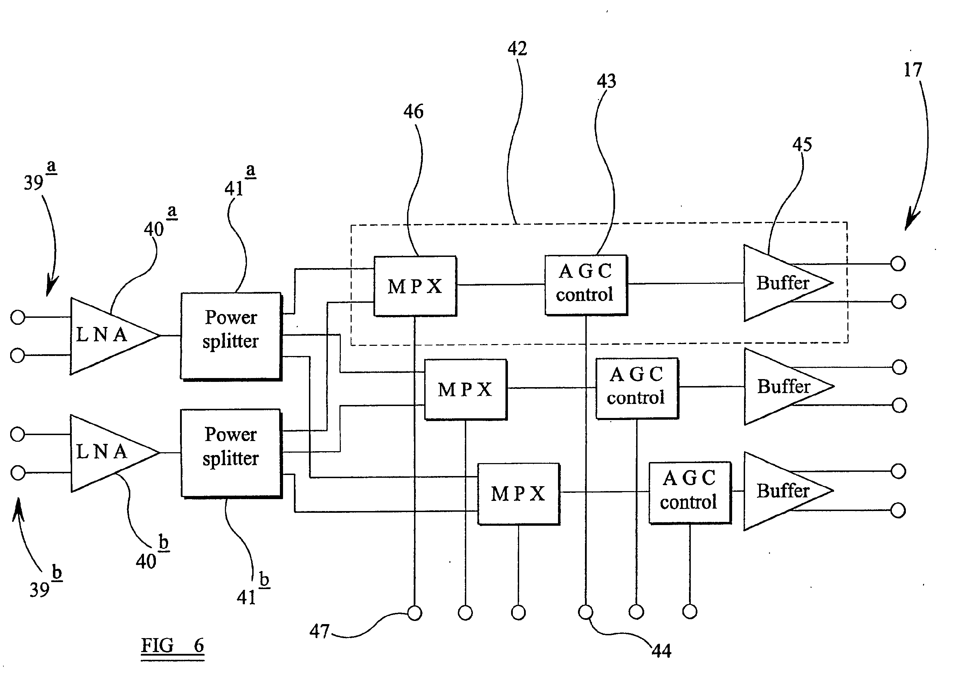

Figure 6 shows another interface which is capable of switching any of a plurality of input signals (two in this case) to any of the outputs. The interface of Figure 6 differs from that shown in Figure 4 in that the single differential input 39 is replaced by two differential inputs 39a and 39b, the single LNA 40 is replaced two LNAs 40a and 40b, the single power splitter 41 is replaced by two power splitters 41a and 41b, and each channel 42 has a multiplexer 46 between the power splitters 41a and 41b and the AGC control circuit 43. The LNAs 40a and 40b are substantially identical to the LNA 40 and the power splitters 41a and 41b are substantially identical to the power splitter 41.

The multiplexer (MPX) 46 has first and second inputs connected to outputs of the power splitters 41a and 41b, respectively. The multiplexer 46 also has a control input 47 for selecting which input is connected to its output. Thus, each channel may supply, independently of the other channels, any of the input signals to its output in accordance with a control signal supplied to the control input 47 of the multiplexer 46.

## Claims

1. An input interface for interfacing between a radio frequency input (1) and a plurality of radio frequency tuners (22-32), comprising a broadband active multipath power splitter having at least one input for receiving a broadband radio frequency signal, a plurality of output channels (42), and at least one active power splitting circuit (41, 41a, 41b) for supplying the broadband frequency signal to each of the output channels (42), **characterised in that** the active power splitting circuit (41, 41 a, 41 b) is a non-reactive power splitting circuit and at least one of the output channels (42) comprises an automatic gain control circuit (43) having a single-ended output connected to the input of a differential output buffer (45) having a differential output forming the output (17) of the channel (42).

2. An interface as claimed in claim 1, **characterised in that** the or each differential output (17) is arranged to supply a signal having substantially the same characteristics as the broadband radio frequency signal.

3. An interface as claimed in claim 2, **characterised in that** the characteristics include impedance.

4. An interface as claimed in claim 2 or 3, **characterised in that** the characteristics include the shape of the distribution of signal level with respect to frequency.

5. An interface as claimed in any one of the preceding claims, **characterised by** comprising an amplifier (40, 40a, 40b) for supplying the radio frequency signal to the power splitter input.

6. An interface as claimed in any one of the preceding claims, **characterised in that** the at least one input comprises a plurality of inputs, the at least one splitting circuit comprises a plurality of splitting circuits (41 a, 41 b), and the at least one channel (42) comprises a multiplexer (46) for connecting the output of any selected one of the splitting circuits (41 a, 41b) to the input of the automatic gain control circuit (46).

7. An interface as claimed in any one of the preceding claims, **characterised in that** the gain of the automatic gain control circuit (43) is controllable to be substantially zero.

8. An interface as claimed in any one of the preceding claims, **characterised by** being formed as a single monolithic integrated circuit.

9. A combination of an interface as claimed in any one of the preceding claims and at least one tuner (22-32) connected to the differential output (17).

10. A combination as claimed in claim 9, **characterised in that** the tuner (22-32) has a differential input connected to the differential output (17).

11. A combination as claimed in claim 10, **characterised in that** the tuner (22-32) has a mixer (23) with a balanced input connected to the differential input.

12. A combination as claimed in claim 11, **characterised in that** the mixer (23) is a double-balanced mixer.

13. A combination as claimed in any one of claims 9 to 12, **characterised by** being disposed in a common enclosure.

## Patentansprüche

1. Eingangsschnittstelle für Anbindung zwischen einem Hochfrequenzeingang (1) und einer Pluralität von Hochfrequenzabstimmvorrichtungen (22-32), umfassend einen aktiven Breitband-Mehrweg-Leistungsteiler, der mindestens einen Eingang zum Empfangen eines Breitband-Hochfrequenzsignals aufweist, eine Pluralität von Ausgangskanälen (42) und mindestens einen aktiven Leistungsteilungsschaltkreis (41, 41a, 41b) zum Zuführen des Breitbandfrequenzsignals zu jedem der Ausgangskanäle (42), **dadurch gekennzeichnet, dass** der aktive Leistungsteilungsschaltkreis (41, 41a, 41b) ein reaktionsfreier Leistungsteilungsschaltkreis ist und mindestens einer der Ausgangskanäle (42) einen automatischen Verstärkungssteuerungsschaltkreis (43) umfasst, der einen unsymmetrischen Ausgang aufweist, der verbunden ist mit dem Eingang eines Differenzialausgangspuffers (45), der einen Differenzialausgang aufweist, der den Ausgang (17) des Kanals (42) bildet.

2. Schnittstelle nach Anspruch 1, **dadurch gekennzeichnet, dass** der oder jeder Differenzialausgang (17) angeordnet ist zur Bereitstellung eines Signals, das im Wesentlichen die gleichen Charakteristika wie das Breitband-Hochfrequenzsignal hat.

3. Schnittstelle nach Anspruch 2, **dadurch gekennzeichnet, dass** die Charakteristika die Impedanz enthalten.

4. Schnittstelle nach Anspruch 2 oder 3, **dadurch gekennzeichnet, dass** die Charakteristika die Form der Verteilung des Signalpegels in Bezug auf die Frequenz enthalten.

5. Schnittstelle nach einem der vorstehenden Ansprüche, **gekennzeichnet durch** Umfassen eines Verstärkers (40, 40a, 40b) zur Bereitstellung des Hochfrequenzsignals zu dem Leistungsteilereingang.

6. Schnittstelle nach einem der vorstehenden Ansprüche, **dadurch gekennzeichnet, dass** der mindestens eine Eingang eine Pluralität von Eingängen umfasst, der mindestens eine Teilungsschaltkreis eine Pluralität von Teilungsschaltkreisen (41a, 41b) umfasst und der mindestens eine Kanal (42) einen Multiplexer (46) umfasst zum Verbinden des Ausgangs eines beliebigen ausgewählten der Teilungsschaltkreise (41a, 41b) mit dem Eingang des automatischen Verstärkungssteuerungsschaltkreises (46).

7. Schnittstelle nach einem der vorstehenden Ansprüche, **dadurch gekennzeichnet, dass** die Verstärkung des automatischen Verstärkungssteuerungsschaltkreises (43) so steuerbar ist, dass sie im Wesentlichen null ist.

8. Schnittstelle nach einem der vorstehenden Ansprüche, **gekennzeichnet durch** Ausbildung als ein einzelner monolithisch integrierter Schaltkreis.

9. Kombination einer Schnittstelle nach einem der vorstehenden Ansprüche und mindestens einer Abstimmvorrichtung (22-32), die mit dem Differenzialausgang (17) verbunden ist.

10. Kombination nach Anspruch 9, **dadurch gekennzeichnet, dass** die Abstimmvorrichtung (22-32) einen Differenzialeingang aufweist, der mit dem Differenzialausgang (17) verbunden ist.

11. Kombination nach Anspruch 10, **dadurch gekennzeichnet, dass** die Abstimmvorrichtung (22-32) eine Mischeinrichtung (23) mit einem symmetrischen Eingang aufweist, der mit dem Differenzialeingang verbunden ist.

12. Kombination nach Anspruch 11, **dadurch gekennzeichnet, dass** die Mischeinrichtung (23) ein Ringmischer ist.

13. Kombination nach einem der Ansprüche 9 bis 12, **gekennzeichnet durch** Anordnung in einem gemeinsamen Gehäuse.

## Revendications

1. Interface d'entrée pour s'interfacer entre une entrée radiofréquence (1) et une pluralité de syntoniseurs radiofréquences (22-32), comprenant un séparateur de puissance multi-chemin actif à large bande ayant au moins une entrée pour recevoir un signal radiofréquence à large bande, une pluralité de canaux de sortie (42), et au moins un circuit de séparation de puissance actif (41, 41a, 41b) pour fournir le signal de fréquence à large bande à chacun des canaux de sortie (42), **caractérisée en ce que** le circuit de séparation de puissance actif (41, 41a, 41b) est un circuit de séparation de puissance non-réactif et au moins un des canaux de sortie (42) comprend un circuit de commande de gain automatique (43) ayant une sortie à extrémité unique raccordée à l'entrée d'un tampon de sortie différentielle (45) ayant une sortie différentielle formant la sortie (17) du canal (42).

2. Interface selon la revendication 1, **caractérisée en ce que** la ou chaque sortie différentielle (17) est disposée pour fournir un signal ayant substantiellement les mêmes caractéristiques que le signal radiofréquence à large bande.

3. Interface selon la revendication 2, **caractérisée en ce que** les caractéristiques comprennent l'impédance.

4. Interface selon la revendication 2 ou 3, **caractérisée en ce que** les caractéristiques comprennent la forme de la distribution du niveau de signal par rapport à la fréquence.

5. Interface selon l'une quelconque des revendications précédentes, **caractérisée en ce qu'**il comprend un amplificateur (40, 40a, 40b) pour fournir le signal radiofréquence à l'entrée de séparateur de puissance.

6. Interface selon l'une quelconque des revendications précédentes, **caractérisée en ce que** l'au moins une entrée comprend une pluralité d'entrées, l'au moins un circuit de séparation comprend une pluralité de circuits de séparation (41a, 41b), et l'au moins un canal (42) comprend un multiplexeur (46) pour raccorder la sortie d'un quelconque sélectionné des circuits de séparation (41a, 41b) à l'entrée du circuit de commande de gain automatique (46).

7. Interface selon l'une quelconque des revendications précédentes, **caractérisée en ce que** le gain du circuit de commande de gain automatique (43) est commandable pour être substantiellement nul.

8. Interface selon l'une quelconque des revendications précédentes, **caractérisée en ce qu'**elle est formée comme un circuit intégré monolithique unique.

9. Combinaison d'une interface selon l'une quelconque des revendications précédentes et au moins un syntoniseur (22-32) raccordé à la sortie différentielle (17).

10. Combinaison selon la revendication 9, **caractérisée en ce que** le syntoniseur (22-32) a une entrée différentielle raccordée à la sortie différentielle (17).

11. Combinaison selon la revendication 10, **caractérisée en ce que** le syntoniseur (22-32) a un mélangeur (23) avec une entrée équilibrée raccordée à l'entrée différentielle.

12. Combinaison selon la revendication 11, **caractérisée en ce que** le mélangeur (23) est un mélangeur double équilibré.

13. Combinaison selon l'une quelconque des revendications 9 à 12, **caractérisée en ce qu'**elle est disposée dans une enceinte commune.
